# EUROPÄISCHE PATENTSCHRIFT

(11) **EP 1 046 047 B1**
(45) Veröffentlichungstag und Bekanntmachung des Hinweises auf die Patenterteilung: **07.06.2006**
(21) Anmeldenummer: 99936399.7
(22) Anmeldetag: 02.06.1999
(51) Int. Cl.: G01R 33/09, H01L 43/08, H01F 10/08

(54) **MAGNETORESISTIVES SENSORELEMENT MIT WAHLWEISER MAGNETISIERUNGSAUSRICHTUNG DER BIASSCHICHT**
MAGNETORESISTIVE SENSOR ELEMENT WITH SELECTIVE MAGNETIZATION DIRECTION OF THE BIAS LAYER
ELEMENT DETECTEUR MAGNETORESISTIF AVEC POSSIBILITE DE CHOISIR LE SENS D'AIMANTATION DE LA COUCHE DE POLARISATION

(30) Priorität: 22.09.1998 DE 19843348
(43) Veröffentlichungstag der Anmeldung: 25.10.2000
(73) Patentinhaber: ROBERT BOSCH GMBH, 70442 Stuttgart (DE)
(72) Erfinder: MARX, Klaus, D-70563 Stuttgart (DE); KITTEL, Hartmut, D-71287 Weissach-Flacht (DE); JOST, Franz, D-70565 Stuttgart (DE); FREITAG, Martin, D-81543 München (DE)
(86) Internationale Anmeldenummer: PCT/DE1999/001631
(87) Internationale Veröffentlichungsnummer: WO 2000/017667

(56) Entgegenhaltungen:
- DE-A- 19 520 172
- VAN DEN BERG H A M ET AL: "GMR angle detector with an artificial antiferromagnetic subsystem (AAF)" JOURNAL OF MAGNETISM AND MAGNETIC MATERIALS, Bd. 165, Nr. 1, 1. Januar 1997 (1997-01-01), Seite 524-528 XP004058131 ISSN: 0304-8853 in der Anmeldung erwähnt
- PATENT ABSTRACTS OF JAPAN vol. 199, no. 709, 30. September 1997 (1997-09-30) & JP 09 126780 A (TOKIN CORP), 16. Mai 1997 (1997-05-16)

## Beschreibung

Die vorliegende Erfindung betrifft ein magnetoresistives Sensorelement, insbesondere ein Winkelsensorelement, nach dem Oberbegriff des Patentanspruchs 1 sowie ein Verfahren zur Bestimmung einer Richtung eines Magnetfeldes nach dem Oberbegriff des Patentanspruchs 6.

Sensoren, insbesondere Winkelsensoren, die auf der Grundlage des magnetoresistiven Effektes arbeiten, sind bekannt. Hierbei wird der elektrische Widerstand von Sensorelementen in Abhängigkeit von der Richtung eines äußeren Magnetfeldes gemessen. Verwendung finden insbesondere den anisotropen magnetorestistiven Effekt ausnutzende, sogenannte AMR-Sensoren. Es sind ebenfalls Systeme beschrieben worden, bei welchen sogenannte GMR-Sensorelemente (engl.: Giant-Magneto-Resistance-Effect), insbesondere unter Verwendung von selbstabilisierenden magnetischen Schichten, eingesetzt werden (van den Berg et. al., GMR angle detector with an artificial antiferromagnetic subsystem, Journal of Magnetism and Magnetic Materials 165 (1997) 524-528). Hierbei wird eine erste dünne, sogenannte Referenzschicht dadurch erzeugt, daß zwischen zwei entgegengesetzt magnetisierten Lagen (beispielsweise aus Co) eine antiferromagnetische Kopplungsschicht (beispielsweise aus Cu oder Ru) eingebracht wird. Die magnetische Stabilität der Referenzschicht ist durch diesen Mehrschicht-Aufbau gegenüber einzelnen Co-Schichten um etwa eine Größenordnung erhöht. Die Magnetisierungsrichtung der Referenzschicht, die sogenannte Referenzrichtung, hängt (im Idealfall) nicht von der Richtung des äußeren (zu messenden) Magnetfeldes ab.

Aus der DE 19520172 A ist eine Magnetisierungseinrichtung für ein magnetoresistives Dünnschicht-Sensorelement mit einem Biasschichtteil bekannt. Mit der Einrichtung ist die Magnetisierungsverteilung des Biasschichtteils eines Sensorelements einzuprägen. Dieses Element weist einen Dünnschichtaufbau auf einem Substrat auf und zeigt einen erhöhten magnetoresistiven Effekt. Die Einrichtung soll einen elektrisch leitenden Leiterbahnteil und Mittel zur Positionierung dieses Leiterbahnteils bezüglich des Sensorelements enthalten. Über den Leiterbahnteil soll dabei ein vorbestimmter Einstellstrom zu führen sein, so dass in dem Biasschichtteil des Sensorelements die vorbestimmte Magnetisierungsverteilung fest einstellbar ist.

Die Referenzschicht ist mit einer dünnen nicht-magnetischen Schicht abgedeckt, auf der wiederum eine dünne weichmagnetische Schicht, die sogenannte Detektionsschicht, ausgebildet ist. Die Detektionsschicht richtet ihre Magnetisierung in Richtung eines äußeren Magnetfeldes aus. Aus der Theorie des magnetoresistiven Effektes ist bekannt, daß ein Sensorsignal einer Funktion R(α) - R₀+ ΔR*sin(α) bzw. R(α) = R₀ + ΔR*cos(α) folgt, wobei R₀ ein Offsetwiderstand, ΔR ein Signalhub des Sensors und α der zu messende Winkel zwischen einer ausgezeichneten Sensorrichtung (insbesondere der Referenzrichtung) und der Richtung des äußeren Magnetfeldes ist.

Derartige AMR-bzw. GMR-Sensoren sind nur mit großem Aufwand als 360°-Winkelsensoren verwendbar. Insbesondere ist es zur Erzielung von ausreichend genauen Meßergebnissen notwendig, wenigstens zwei Sensorelemente zu verschalten, deren jeweilige Sensorsignale rechnerisch verknüpft werden müssen. Bei Verwendung von GMR-Werkstoffen stellt man ferner eine Zerstörung der Sensorfunktion im Falle zu starker Magnetfelder fest.

Es sind ferner auf Hall-Basis arbeitende Winkelsensorelemente bekannt, welche jedoch üblicherweise nur einen Winkelbereich von 120° abdecken können.

Aufgabe der Erfindung ist daher die Schaffung eines Sensors, insbesondere eines Winkelsensors, mit dem der Bereitstellungsaufwand bzw. der Meßaufwand während des Betriebes gegenüber herkömmlichen Sensoren vermindert werden kann.

Diese Aufgabe wird gelöst durch ein Sensorelement mit den Merkmalen des Patentanspruchs 1 sowie durch ein Verfahren zur Bestimmung der Richtung eines Magnetfeldes mit den Merkmalen des Patentanspruchs 6.

Erfindungsgemäß ist nun ein Sensorelement bzw. ein Sensor geschaffen, welcher gegenüber herkömmlichen Vorrichtungen dieser Art einen wesentlich einfacheren und kostengünstiger zu realisierenden Aufbau aufweist. Ein Zusammenschalten einer Anzahl von Sensorelementen ist nun nicht mehr nötig, ein zu messender Winkel kann in einfacher Weise mit nur einem Sensorelement ermittelt werden. Somit entfällt auch ein kostenintensives Aufbringen mehrerer Sensorelemente auf ein Substrat. Offset und Empfindlichkeit des Sensorelements sind verbessert, da kein Abgleich unterschiedlicher Sensorelemente durchgeführt werden muß.

Bevorzugte Einsatzgebiete für das erfindungsgemäße Sensorelement sind Lenkradwinkelgeber für die Fahrdynamikregelung von Kraftfahrzeugen, Nockenwellensignalgeber, beispielsweise zur Steuerung eines Motor-Direktstarts, DVE-Drosselverstelleinheiten oder Schiebedachregler.

Vorteilhafte Ausgestaltungen des erfindungsgemäßen Sensorelements bzw. des erfindungsgemäßen Verfahrens sind Gegenstand der Unteransprüche.

Es ist besonders bevorzugt, daß die unterschiedlichen Referenzrichtungen um 90° gegeneinander versetzt sind. Mit dieser Maßnahme lassen sich beispielsweise in einfacher Weise linear unabhängige, insbesondere dem Sinus und Cosinus der Drehrichtung des äußeren Magnetfeldes zugeordnete Signale erzeugen. Unter Verwendung beispielsweise der Arctan-Funktion läßt sich dann in bekannter Weise mit geringem Aufwand die Drehrichtung bzw. der Winkel des äußeren Magnetfeldes bezüglich einer ausgezeichneten Richtung, beispielsweise einer der zwei Referenzrichtungen, bestimmen.

Zweckmäßigerweise werden die Mittel zur wahlweisen Ausrichtung der Magnetisierungsrichtung von einem Stromleiter gebildet, der von der ersten Schicht mittels einer Isolatorschicht galvanisch getrennt und zur Stromführung in unterschiedlichen Richtungen, insbesondere um 90° zueinander versetzten Richtungen, ausgebildet ist. Mit einem derartigen sogenannten Biasstrom ist die wahlweise Ausrichtung der Magnetisierungsrichtung in einfacher und zuverlässiger Weise erzielbar. Insbesondere mittels Regelung der Stromstärke des Biasstroms ist eine Anpassung der Sensorgenauigkeit an die magnetische Umgebung möglich. Es treten keine thermischen Drifts in dem Sensorelement auf, da der Biasstrom in der Zeit konstant ist bzw. in einfacher Weise konstant regelbar ist. Da zur Schaffung der Referenzmagnetisierung kein hartmagnetisches Material verwendet werden muß, tritt erfindungsgemäß im Falle starker Magnetfelder keine Beeinträchtigung oder Zerstörung der Sensorfunktion auf. Derartige Sensorelemente weisen einen weiten Temperatur-Einsatzbereich auf und sind insbesondere für Kraftfahrzeuge einsetzbar.

Zweckmäßigerweise ist die erste Schicht aus einem weichmagnetischen Werkstoff hergestellt. Derartige Werkstoffe sind preiswert verfügbar und mittels eines stromleiterinduzierten Magnetfeldes (Biasstrom) magnetisierbar.

Vorteilhafterweise ist auch die dritte Schicht, die Detektionsschicht des Sensorelements, aus einem weichmagnetischen Werkstoff hergestellt. Hiermit ist eine genaue und verzögerungsfreie Anpassung der Magnetisierungsrichtung der Detektionsschicht an die Richtung des äußeren Magnetfeldes erzielbar.

Gemäß einer bevorzugten Ausführungsform des erfindungsgemäßen Verfahrens handelt es sich bei einem der Sensorsignale um ein dem Sinus des Winkels zwischen der ersten Referenzrichtung und der Magnetisierungsrichtung der dritten Schicht zugeordnetes, und bei einem weiteren der Sensorsignale um ein dem Cosinus des Winkels zwischen der zweiten Referenzrichtung und der Magnetisierungsrichtung der dritten Schicht zugeordnetes Signal. Derartige Signale sind, insbesondere unter Verwendung der Arctan-Funktion, in einfacher Weise auswertbar.

Die Erfindung wird nun anhand einer bevorzugten Ausführungsform unter Bezugnahme auf die beigefügte Zeichnung im einzelnen erläutert. In dieser zeigt
- Figur 1: eine schematische Schnittansicht des Schichtaufbaus einer bevorzugten Ausführungsform des erfindungsgemäßen Sensorelements,
- Figur 2: eine perspektivische Ansicht der oberen drei Schichten des Sensorelements der Figur 1 mit eingezeichneten Magnetisierungsrichtungen (erste Referenzrichtung),
- Figur 3: eine perspektivische Ansicht der oberen drei Schichten des Sensorelements der Figur 1 mit eingezeichneten Magnetisierungsrichtungen (zweite Referenzrichtung),
- Figur 4: den Verlauf des Sensorsignals bei Vorliegen der ersten Referenzrichtung,
- Figur 5: den Verlauf des Sensorsignals bei Vorliegen der zweiten Referenzrichtung,
- Figur 6: eine Draufsicht auf die eine bevorzugte Ausführungsform der Stromleiterschicht des erfindungsgemäßen Sensorelements (ohne die darüberliegenden Schichten),
- Figur 7: ein Diagramm zur Erläuterung der Strombeaufschlagung der Stromleiterschicht der Figur 6, und
- Figur 8: eine perspektivische Ansicht einer bevorzugten Anwendung des erfindungsgemäßen Sensorelements.

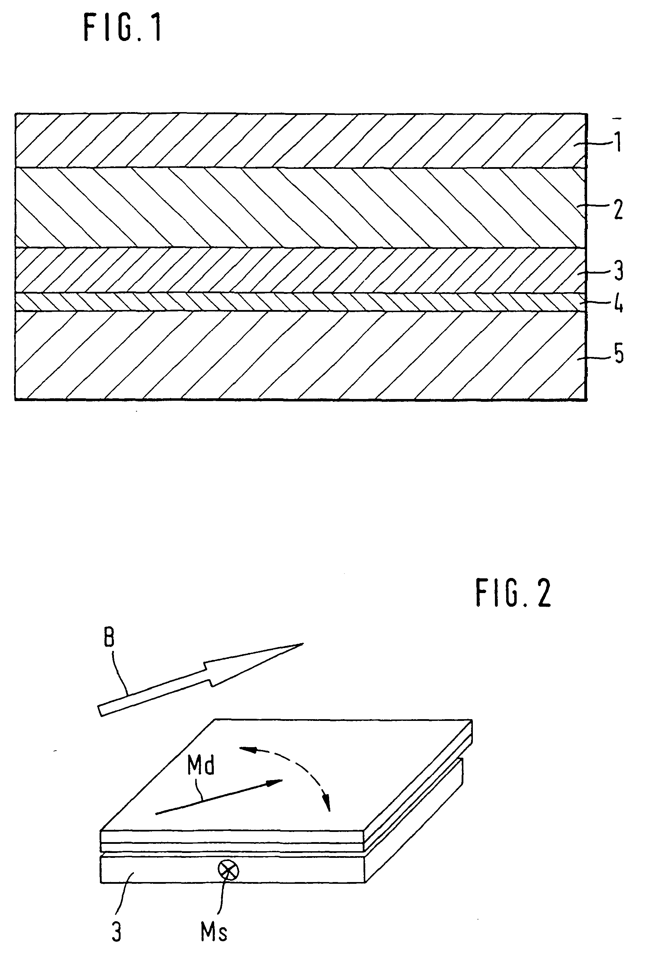

In Figur 1 ist ein bevorzugter Schichtaufbau eines erfindungsgemäßen Sensorelements schematisch dargestellt. Das Sensorelement weist eine dünne magnetische, vorzugsweise weichmagnetische, Schicht 3 (Referenzschicht 3) auf. Die Magnetisierungsrichtung dieser Referenzschicht 3 stellt die Referenzrichtung des Sensorelements dar. Auf die Referenzschicht 3 ist eine dünne, nichtmagnetische Leiterschicht 2 aufgebracht, auf welcher eine weitere vorzugsweise weichmagnetische Schicht 1 (Detektionsschicht) ausgebildet ist. Die Magnetisierungsrichtung dieser Detektionsschicht 1 ist abhängig von der Richtung eines (parallel zur Schichtoberfläche orientierten) äußeren Magnetfeldes B, wie weiter unten im einzelnen erläutert wird.

Unter der Referenzschicht 3 ist eine Isolatorschicht 4 ausgebildet, welche die Referenzschicht 3 galvanisch von einer als Stromleiter ausgebildeten Schicht 5 trennt. In Abhängigkeit von der Stromrichtung in der Stromleiterschicht 5 wird in der Referenzschicht 3 ein Magnetfeld induziert, was zu einer entsprechenden Magnetisierung der Referenzschicht 3 führt.

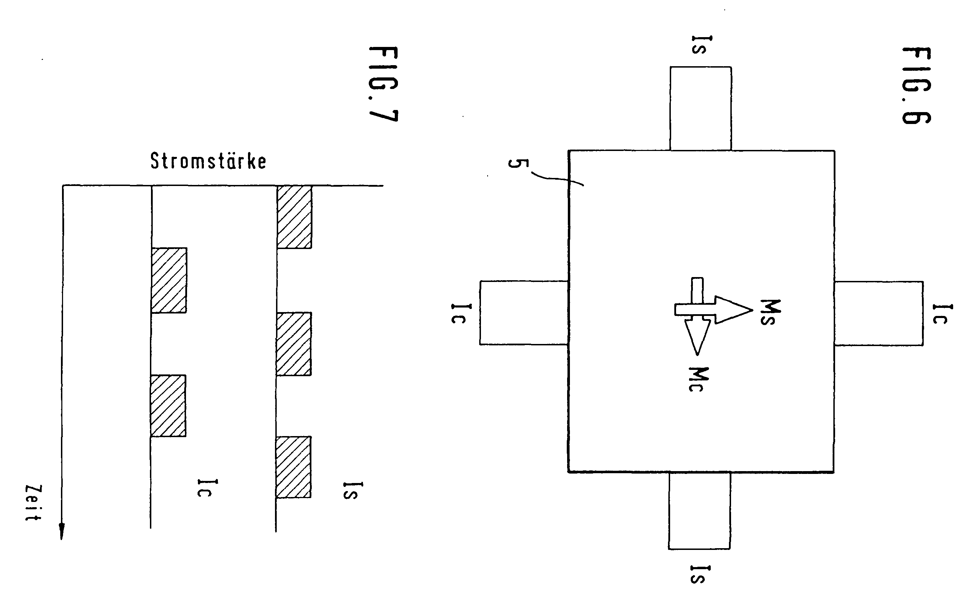

Der Zusammenhang zwischen Stromrichtung in der Schicht 5 und der induzierten Magnetisierung in der Referenzschicht 3 ist in Figur 6 dargestellt. Fließt ein Strom Is gemäß der Darstellung der Figur 6 in waagerechter Richtung wird in der darüber angeordneten, in Figur 6 nicht dargestellten Referenzschicht 3 eine Magnetisierung entsprechend der durch den Pfeil Ms dargestellten Richtung induziert. Bei einem Stromfluß Ic senkrecht hierzu ergibt sich analog eine Magnetisierung in Richtung des Pfeiles Mc. Der Einfachheit halber werden im folgenden sowohl die Magnetisierungsrichtungen bzw. Richtungen von Magnetfeldern darstellenden Pfeile, als auch die entsprechenden Magnetisierungen bzw. Magnetfelder in gleicher Weise bezeichnet.

Eine bevorzugte Ansteuerung der Stromleiterschicht 5 ist in Figur 7 dargestellt. Man erkennt, daß die Stromleiterschicht 5 abwechselnd mit den senkrecht zueinander verlaufenden Strömen Is, Ic beaufschlagt wird.

In Figur 2 ist die Magnetisierung Ms der Referenzschicht 3 bei Anliegen des Stromes Is dargestellt. In dieser Darstellung weist Pfeil Ms in die Zeichenebene hinein. Die zu messende Richtung des äußeren Magnetfeldes ist mittels des Pfeiles B dargestellt. Das Magnetfeld B verursacht in der Detektionsschicht 1 eine entsprechende Magnetisierung, deren Richtung durch den Pfeil Md angedeutet ist. Das Magnetfeld B und die Magnetisierung Md der Detektionsschicht weisen die gleiche Orientierung auf.

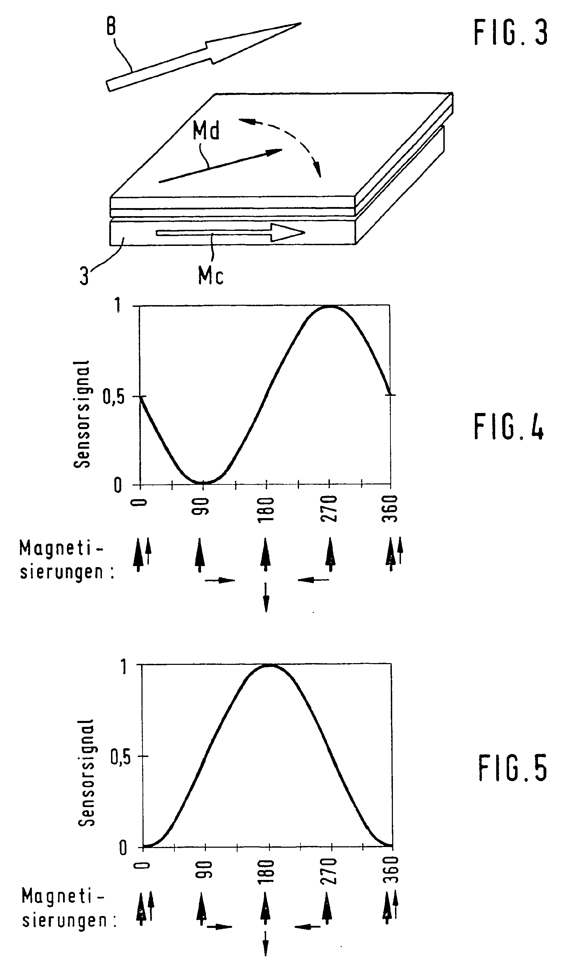

In der Figur 3 weist der die Magnetisierungsrichtung der Referenzschicht 3 darstellende Pfeil Mc in eine Richtung parallel zur Zeichenebene. Diese Magnetisierung ist, wie bereits erläutert, verursacht durch den Strom Ic in der Stromleiterschicht 5.

Ein von dem Sensorelement erzeugtes Spannungssignal ist (beispielsweise bei drehendem Magnetfeld B) abhängig von der relativen Orientierung der Magnetisierungen Ms, Md bzw. Mc, Md. Für die Referenzschicht-Magnetisierung Ms ist diese Abhängigkeit in Figur 4, für die Referenzschicht-Magnetisierung Mc in Figur 5 dargestellt. Zur Veranschaulichung sind in diesen Figuren zusätzlich zu den jeweiligen Winkeln zwischen den Magnetisierungen die Magnetisierung Md mittels einer großen Pfeilspitze, und die Magnetisierungen Ms bzw. Mc mittels kleiner Pfeilspitzen dargestellt.

In Figur 4 erkennt man eine sinusförmige Abhängigkeit des Sensorsignals von dem Winkel zwischen den Magnetisierungen Md und Ms, in Figur 5 entsprechend eine cosinusförmige Abhängigkeit zwischen den Magnetisierungen Md und Mc.

Insgesamt erhält man also für jeden Winkel zwischen dem äußeren Magnetfeld B (bzw. der Richtung der Magnetisierung Md der Detektorschicht 1) und dem Sensorelement ein vom Sinus und ein vom Cosinus dieses Winkels abhängiges Signal. Mit diesen zwei Signalen läßt sich unter Zuhilfenahme der Arcustangens-Funktion der tatsächliche bzw. mechanische Winkel zwischen dem äußeren Magnetfeld B und einer beliebigen ausgezeichneten Richtung, beispielsweise einer der zwei Referenzrichtungen der Referenzschicht 3, bestimmen. Bei herkömmlichen Sensoren war es notwendig, für das Sinussignal und das Cosinussignal jeweils verschiedene, unterschiedlich orientierte Sensorelemente vorzusehen.

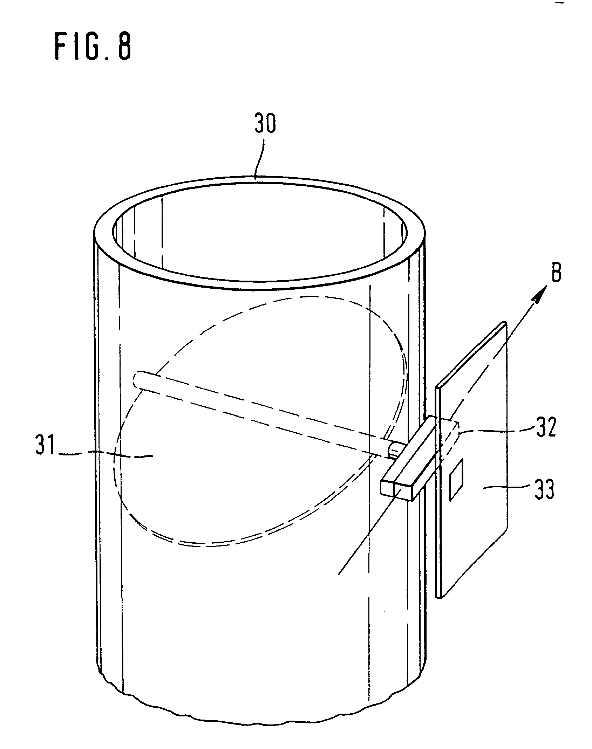

Anhand der Figur 8 wird abschließend ein bevorzugtes Anwendungsbeispiel für das erfindungsgemäße Sensorelement dargestellt. Eine in einem Ansaugrohr 30 eines Verbrennungsmotors vorgesehene Drosselklappe 31 weist an einer außerhalb des Ansaugrohres ausgebildeten Verlängerung einen Magneten 32 auf, welcher entsprechend seiner von der Stellung der Drosselklappe abhängigen Orientierung ein Magnetfeld B erzeuge. In dem Einflußbereich dieses Magnetfeldes B ist ein schematisch dargestelltes (stark vergrößertes) GMR-Sensorelement 33 angeordnet, welches einen Aufbau und eine Funktionsweise wie oben dargestellt aufweist. Das Magnetfeld B ist parallel zu der Oberfläche des Sensorelements 33 (bzw. zu dessen nicht dargestellter Detektionsschicht) ausgerichtet. Mittels lediglich dieses einen Sensorelements ist in der beschriebenen Weise der Drosselklappenwinkel der Drosselklappe 31 in einfacher Weise bestimmbar.

## Patentansprüche

1. Magnetoresistives Sensorelement, insbesondere Winkelsensorelement, mit einer ersten, magnetischen Schicht (3), deren Magnetisierungsrichtung eine Referenzrichtung darstellt, einer auf der ersten Schicht (3) ausgebildeten zweiten, nichtmagnetischen Schicht (2), und einer dritten, auf der zweiten Schicht (2) ausgebildeten magnetischen Schicht (1), deren Magnetisierungsrichtung durch ein äußeres Magnetfeld beeinflußbar ist, **gekennzeichnet durch** Mittel (5) zur abwechselnden, unterschiedlichen Ausrichtung der Magnetisierungsrichtung der ersten Schicht (3) zur Schaffung unterschiedlicher gegeneinander versetzten Referenzrichtungen.

2. Sensorelement nach Anspruch 1, **dadurch gekennzeichnet, daß** die unterschiedlichen Referenzrichtungen um 90° gegeneinander versetzt sind.

3. Sensorelement nach einem der Ansprüche 1 oder 2, **dadurch gekennzeichnet, daß** die Mittel (5) von einem Stromleiter gebildet werden, der von der ersten Schicht (3) mittels einer Isolatorschicht (4) galvanisch getrennt und zur Stromführung in unterschiedlichen Richtungen, insbesondere um 90° zueinander versetzten Richtungen, ausgebildet ist.

4. Sensorelement nach einem der vorstehenden Ansprüche, **dadurch gekennzeichnet, daß** die erste Schicht (3) aus einem weichmagnetischen Werkstoff hergestellt ist.

5. Sensorelement nach einem der vorstehenden Ansprüche, **dadurch gekennzeichnet, daß** die dritte Schicht (1) aus einem weichmagnetischen Werkstoff hergestellt ist.

6. Verfahren zur Bestimmung einer Richtung eines Magnetfeldes unter Verwendung eines Sensorelements nach einem der vorstehenden Ansprüche, **dadurch gekennzeichnet, daß** durch die Mittel (5) abwechselnd unterschiedliche Referenzrichtungen in der ersten Schicht (3) des Sensorelements erzeugt werden, wobei für jede Referenzrichtung ein Sensorsignal in Abhängigkeit von einem Winkel zwischen der jeweiligen Referenzrichtung und einer durch das Magnetfeld induzierten Magnetisierungsrichtung der dritten Schicht (1) des Sensorelements ermittelt wird.

7. Verfahren nach Anspruch 6, **dadurch gekennzeichnet, daß** es sich bei einem der Sensorsignale um ein dem Sinus des Winkels zwischen der ersten Referenzrichtung und der Magnetisierungsrichtung der dritten Schicht (1) zugeordnetes, und bei einem weiteren der Sensorsignale um ein dem Cosinus des Winkels zwischen der zweiten Referenzrichtung und der Magnetisierungsrichtung der dritten Schicht (1) zugeordnetes Signal handelt.

## Claims

1. Magnetoresistive sensor element, in particular angle sensor element, having a first, magnetic layer (3) whose magnetization direction represents a reference direction, a second, nonmagnetic layer (2) which is formed on the first layer (3), and a third, magnetic layer (1) which is formed on the second layer (2) and whose magnetization direction can be influenced by an external magnetic field, **characterized by** means (5) for alternately orienting the magnetization direction of the first layer (3) in a different manner in order to provide different reference directions which are offset with respect to one another.

2. Sensor element according to Claim 1, **characterized in that** the different reference directions are offset by 90° with respect to one another.

3. Sensor element according to either of Claims 1 and 2, **characterized in that** the means (5) are formed by a current conductor which is electrically isolated from the first layer (3) by means of an insulator layer (4) and is designed to carry current in different directions, in particular directions which are offset by 90° to one another.

4. Sensor element according to one of the preceding claims, **characterized in that** the first layer (3) is produced from a soft-magnetic material.

5. Sensor element according to one of the preceding claims, **characterized in that** the third layer (1) is produced from a soft-magnetic material.

6. Method for determining the direction of a magnetic field using a sensor element according to one of the preceding claims, **characterized in that** the means (5) alternately produce different reference directions in the first layer (3) of the sensor element, with a sensor signal being determined for each reference direction as a function of an angle between the respective reference direction and a magnetization direction of the third layer (1) of the sensor element, this magnetization direction being induced by the magnetic field.

7. Method according to Claim 6, **characterized in that** one of the sensor signals is a signal which is associated with the sine of the angle between the first reference direction and the magnetization direction of the third layer (1), and a further one of the sensor signals is a signal which is associated with the cosine of the angle between the second reference direction and the magnetization direction of the third layer (1).

## Revendications

1. Élément détecteur magnétorésistif, notamment élément détecteur d'angle, comprenant une première couche (3) magnétique, dont la direction d'aimantation représente une direction de référence, une deuxième couche (2) non magnétique constituée sur la première couche (3), et une troisième couche (1) magnétique constituée sur la deuxième couche (2) et dont la direction d'aimantation peut être influencée par un champ magnétique extérieur,
**caractérisé par**
des moyens (5) pour l'orientation alternée, différente de la direction d'aimantation de la première couche (3) pour créer des directions de référence différentes, décalées les unes par rapport aux autres.

2. Élément détecteur selon la revendication 1,
**caractérisé en ce que**
les différentes directions de référence sont décalées les unes par rapport aux autres de 90°.

3. Élément détecteur selon l'une des revendications 1 ou 2,
**caractérisé en ce que**
les moyens (5) sont formés par un conducteur galvaniquement séparé de la première couche (3) par une couche d'isolateur (4), et qui pour la conduction du courant est réalisé dans différentes directions, notamment dans des directions décalées de 90° les unes par rapport aux autres.

4. Élément détecteur selon l'une quelconque des revendications précédentes,
**caractérisé en ce que**
la première couche (3) est fabriquée en un matériau magnétique doux.

5. Élément détecteur selon l'une quelconque des revendications précédentes,
**caractérisé en ce que**
la troisième couche (1) est fabriquée à partir d'un matériau magnétique doux.

6. Procédé de détermination d'une direction d'un champ magnétique en utilisant un élément détecteur selon l'une quelconque des revendications ci-dessus,
**caractérisé en ce qu'**
on crée des directions de référence différentes en alternance dans la première couche (3) de l'élément détecteur par les moyens (5), un signal détecteur étant calculé pour chaque direction de référence en fonction d'un angle entre la direction de référence concernée et une direction d'aimantation de la troisième couche (1) de l'élément capteur induite par le champ magnétique.

7. Procédé selon la revendication 6,
**caractérisé en ce que**
l'un des signaux détecteurs est un signal détecteur associé au sinus de l'angle entre la première direction de référence et la direction d'aimantation de la troisième couche (1), et l'autre signal parmi les signaux détecteurs, est un signal associé au cosinus de l'angle entre la deuxième direction de référence et la direction d'aimantation de la troisième couche (1).
